# EUROPÄISCHE PATENTANMELDUNG

(11) **EP 3 451 205 A1**
(43) Veröffentlichungstag der Anmeldung: **06.03.2019**
(21) Anmeldenummer: 18166524.1
(22) Anmeldetag: 10.04.2018
(51) Int. Cl.: G06F 17/50, G06T 19/00, G05B 19/418, G06T 17/10

(54) **VERFAHREN UND COMPUTERSYSTEM ZUR PLANUNG EINER ANLAGE IM BEREICH DER GETRÄNKEVERARBEITUNGSINDUSTRIE**

(30) Priorität: 10.05.2017 DE 102017207894
(71) Anmelder: Krones AG, 93073 Neutraubling (DE)
(72) Erfinder: Seger, Martin, 93073 Neutraubling (DE); Jogsch, Michael, 93073 Neutraubling (DE)
(74) Vertreter: Grünecker Patent- und Rechtsanwälte PartG mbB

(57) **Zusammenfassung**

Verfahren (100) zur Planung einer Anlage im Bereich der Getränkeverarbeitungsindustrie mit wenigstens einer Maschinenkomponente, wobei aufgrund einer Aufgabenvorgabe die wenigstens eine Maschinenkomponente konfiguriert (110) wird, dadurch gekennzeichnet, dass aus der wenigstens einen konfigurierten Maschinenkomponente wenigstens ein zugeordnetes virtuelles 3D-Maschinenmaßblatt erzeugt wird (111), dass eine Realumgebung zur Installation der wenigstens einen Maschinenkomponente mit einem Kamerasystem erfasst wird (120), und dass das wenigstens eine virtuelle 3D-Maschinenmaßblatt in der erfassten Realumgebung virtuell angeordnet wird (122).

## Beschreibung

Die Erfindung betrifft ein Verfahren zur Planung einer Anlage im Bereich der Getränkeverarbeitungsindustrie mit wenigstens einer Maschinenkomponente mit den Merkmalen des Oberbegriffs von Anspruch 1 und ein Computersystem mit einem vorzugsweise stationären Computer sowie einen mobilen Computer zur Planung einer Anlage im Bereich der Getränkeverarbeitungsindustrie.

Üblicherweise wird bei der Planung einer Anlage im Bereich der Getränkeverarbeitungsindustrie während des Angebotsprozesses geklärt, welche Aufgaben die Maschinenkomponenten erfüllen müssen. Aus dieser Information wird dann eine Aufgabenvorgabe generiert und damit die Maschinenkomponenten zu konfigurieren. Beispielsweise wird bei einem Füller in der Aufgabenvorgabe festgelegt, welche Behältertypen zur Verarbeitung mit der Anlage in Frage kommen, und welche Produkte in die Behälter abgefüllt werden sollen. Bei einer Etikettiermaschine wird beispielsweise in der Aufgabenvorgabe festgelegt, welcher Etikettentyp an den Behältern angebracht werden soll. Anschließend wird aus diesen Informationen für jede Maschinenkomponente ein zugeordnetes 2D-Maschinenmaßblatt erzeugt, das anschließend an entsprechender Stelle in ein Layout der Anlage eingefügt wird. Damit kann dem Kunden gezeigt werden, wie die Maschinenkomponenten zueinander gestellt werden müssen und wie groß die Anlage infolgedessen wird.

Nachteilig dabei ist, dass der Planungsprozess zeitaufwendig ist, da beispielsweise Änderungen alle Planungsstationen erneut durchlaufen müssen. Zudem sind damit Risiken verbunden, da die bauseitige Situation beim Anlagenbetreiber und der darin vorgesehenen Maschinenkomponenten im Layout nicht vollständig erfasst wird.

Aufgabe der vorliegenden Erfindung ist es daher, ein Verfahren und ein Computersystem zur Planung einer Anlage im Bereich der Getränkeverarbeitungsindustrie bereitzustellen, die einen schnelleren und sichereren Planungsprozess erlauben.

Zur Lösung dieser Aufgabenstellung stellt die Erfindung ein Verfahren zur Planung einer Anlage im Bereich der Getränkeverarbeitungsindustrie mit wenigstens einer Maschinenkomponente mit den Merkmalen des Anspruchs 1 bereit. Vorteilhafte Ausführungen der Erfindung sind in den Unteransprüchen genannt.

Dadurch, dass aus der wenigstens einen konfigurierten Maschinenkomponente das wenigstens eine zugeordnete virtuelle 3D-Maschinenmaßblatt erzeugt wird, kann die Ausdehnung der jeweiligen Maschinenkomponente nicht nur als 2D-Projektion sondern als 3D-Körper berücksichtigt werden. Folglich können dadurch bei der Planung jeweils unterschiedliche Querschnitte der wenigstens einen Maschinenkomponente in unterschiedlicher Höhe berücksichtigt werden. Dadurch, dass die Realumgebung zur Installation der wenigstens einen Maschinenkomponente mit dem Kamerasystem erfasst wird, werden die tatsächlichen Räumlichkeiten für die Anlage und nicht nur ein möglicherweise unvollständiger oder fehlerhafter Plan erfasst. Daher werden Unterschiede zwischen den tatsächlichen Räumlichkeiten und der Planung vermieden. Da das wenigstens eine virtuelle 3D-Maschinenmaßblatt in der erfassten Realumgebung virtuell angeordnet wird, kann eine Bedienperson besonders zuverlässig und schnell erkennen, ob die wenigstens eine Maschinenkomponente ungehindert aufgestellt werden kann. Beispielsweise kann in der virtuellen Anordnung besonders einfach und zuverlässig überprüft werden, ob die Maschinenkomponente mit einer von oben herabstehenden Einheit, beispielsweise einem Lüftungsschacht, kollidiert. Darüber hinaus ist es mit dem Verfahren möglich, Änderungen in der Planung schnell und zuverlässig zu prüfen.

Das Verfahren kann wenigstens teilweise beim Hersteller und/oder wenigstens teilweise bei einem Anlagenbetreiber durchgeführt werden. Der Hersteller kann die wenigstens eine Maschinenkomponente und/oder die Anlage wenigstens teilweise herstellen. Der Anlagenbetreiber kann mit der wenigstens einen Maschinenkomponente und/oder der Anlage ein Produkt herstellen, verarbeiten und/oder in Tanks, Fässer und/oder Behälter abfüllen. Beispielsweise kann das Verfahren während eines Angebotsprozesses seitens des Herstellers durchgeführt werden, um die Anordnung der wenigstens einen Maschinenkomponente aus einem Angebot in der Realumgebung des Anlagenbetreibers zu prüfen. Beispielsweise kann die Konfiguration der wenigstens einen Maschinenkomponente aufgrund der Aufgabenvorgabe und die Erzeugung des wenigstens einen zugeordneten virtuellen 3D-Maschinenmaßblatts beim Hersteller und die Erfassung der Realumgebung und die Anordnung des wenigstens einen virtuellen 3D-Maschinenmaßblatts in der erfassten Realumgebung beim Anlagenbetreiber erfolgen.

Die wenigstens eine Maschinenkomponente kann eine oder mehrere Behandlungsmaschinen für Behälter umfassen, beispielsweise eine Behälterherstellungsmaschine, eine Behälterreinigungsmaschine, eine Inspektionsmaschine, eine Abfüllmaschine, eine Etikettiermaschine, einen Pasteur, eine Verpackungsmaschine, einen Ent- bzw. Be-Palettierer, einen Abschieber und/oder ein Transporteur. Ebenso kann die wenigstens eine Maschinenkomponente eine Produktverarbeitungsmaschine und/oder Produktherstellungsmaschine umfassen, wie beispielsweise ein Sudhaus, einen Pasteur und dergleichen.

Die Behälter können dazu vorgesehen sein, ein Produkt wie Getränke, Nahrungsmittel, Hygieneartikel, Pasten, chemische, biologische und/oder pharmazeutische Produkte aufzunehmen. Die Behälter können Kunststoffflaschen, Metalldosen oder Glasflaschen sein. Die Anlage im Bereich der Getränkeverarbeitungsindustrie kann dazu vorgesehen sein, das Produkt herzustellen, in die Behälter abzufüllen, sie zu verschließen, zu etikettieren und/oder in Gebinde zu verpacken.

Das Verfahren kann dazu vorgesehen sein, die Anordnung der wenigstens einen Maschinenkomponente in der Anlage im Bereich der Getränkeverarbeitungsindustrie zu planen. Denkbar ist, dass damit die gesamte Anlage oder auch nur ein Teil der Anlage geplant wird. Beispielsweise können sich bereits in der Anlage bestehende Maschinenkomponenten befinden, wobei mit dem Verfahren die Anordnung der wenigstens einen Maschinenkomponente zusätzlich zu den bestehenden Maschinenkomponenten geplant wird. Vorzugsweise kann die wenigstens eine Maschinenkomponente wenigstens eine bestehende Maschinenkomponente und wenigstens eine zusätzliche (neue) Maschinenkomponente umfassen. Denkbar ist jedoch auch, dass nur die wenigstens eine zusätzliche Maschinenkomponente mit dem Verfahren konfiguriert und daraus das wenigstens eine virtuelle 3D-Maschinenmaßblatt erzeugt wird und die wenigstens eine bestehende Maschinenkomponente über die Erfassung der Realumgebung berücksichtigt wird.

Bei der Aufgabenvorgabe kann es sich beispielsweise um Parameter aus einem Angebot, einem Lastenheft und/oder aus einem Pflichtenheft für die Anlage handeln. Bei der Aufgabenvorgabe kann es sich beispielsweise um eine Vorgabe handeln, dass eine oder mehrere Maschinenkomponenten als Rundläufermaschinen ausgebildet sein müssen. Ebenso kann es sich dabei um einen Maschinenkomponententyp, eine Maschinenleistung, einen zu verarbeitenden Behältertyp und/oder dergleichen handeln.

Beim Konfigurieren kann die Aufgabenvorgabe dazu herangezogen werden, den genauen geometrischen Aufbau der wenigstens einen Maschinenkomponente festzulegen. Zudem kann der funktionale Aufbau festgelegt werden.

Das wenigstens eine zugeordnete virtuelle 3D-Maschinenmaßblatt kann ein dreidimensionales Geometriemodell der wenigstens einen konfigurierten Maschinenkomponente sein. Beispielsweise kann es sich bei dem Geometriemodell um eine Vielzahl von Dreiecks- und/oder Vierecksflächenelementen handeln, die wenigstens ein zusammenhängendes Flächennetzwerk bilden und die die Ausdehnung der wenigstens einen Maschinenkomponente repräsentieren. Ebenso kann es sich bei dem Geometriemodell um CAD-Daten der wenigstens einen konfigurierten Maschinenkomponente handeln. Denkbar ist auch, dass es sich um ein schematisches Geometriemodell handelt, das die wesentlichen Maße der wenigstens einen Maschinenkomponente als 3D-Modell repräsentiert. Bei der Erzeugung des wenigstens einen zugeordneten virtuellen 3D-Maschinenmaßblatts können beispielsweise mehrere in einer Datenbank abgespeicherte Geometriemodule einer einzigen Maschinenkomponente aufgrund der Konfiguration kombiniert werden.

Die Realumgebung kann beispielsweise einen für die Anlage im Bereich der Getränkeverarbeitungsindustrie vorgesehenen Raum, eine Maschinenhalle und/oder ein Gebäude umfassen. Zudem kann die Realumgebung wenigstens eine bestehende Maschinenkomponente umfassen, die bei der Planung durch zusätzliche Maschinenkomponenten ergänzt werden soll. Vorzugsweise kann die Realumgebung einen Boden umfassen, auf dem die wenigstens eine Maschinenkomponente installiert werden soll.

Die Realumgebung kann mit dem Kamerasystem als Video oder Sequenz von Kamerabildern erfasst werden. Ebenso ist denkbar, dass die Realumgebung mit dem Kamerasystem als 3D-Szene erfasst wird. Vorzugsweise kann bei dem Verfahren ein Standpunkt des Kamerasystems gegenüber der Realumgebung ermittelt werden, um das wenigstens eine virtuelle 3D-Maschinenmaßblatt unabhängig von einer Bewegung des Kamerasystems an derselben Position in der erfassten Realumgebung anzuordnen. Darüber hinaus kann mit dem Verfahren der Boden als Fläche erkannt werden, um darauf das wenigstens eine virtuelle 3D-Maschinenmaßblatt anzuordnen.

Dass "das wenigstens eine virtuelle 3D-Maschinenmaßblatt in der erfassten Realumgebung virtuell angeordnet wird" kann hier bedeuten, dass wenigstens ein konfiguriertes Geometriemodell der wenigstens einen Maschinenkomponente aufgrund von wenigstens einer Positionsvorgabe in der erfassten Realumgebung virtuell angeordnet wird. Vorzugsweise kann die virtuelle Anordnung einer Bedienperson auf einem Bildschirm, einer Datenbrille oder dergleichen angezeigt werden. Beispielsweise kann die virtuelle Anordnung eine perspektivische Projektion des virtuellen 3D-Maschinenmaßblatts in die erfasste Realumgebung umfassen.

Von dem Hersteller können mehrere der Maschinenkomponenten konfiguriert und die zugeordneten virtuellen 3D-Maschinenmaßblätter für den Anlagenbetreiber als alternative Maschinenvarianten in einer Datenbank abgelegt werden, wobei die zugeordneten virtuellen 3D-Maschinenmaßblätter aus der Datenbank über eine Netzwerkdatenverbindung an den Anlagenbetreiber übertragen und wahlweise in der erfassten Realumgebung virtuell angeordnet werden. Dadurch ist es möglich, dem Anlagenbetreiber als Kunden die alternativen Maschinenvarianten vorzuschlagen, um deren Anordnung in der Realumgebung schnell und zuverlässig zu überprüfen. Unter einer Netzwerkdatenverbindung werden alle Übertragungswege digitaler Daten verstanden, sei es eine Datenleitung, eine Internetverbindung oder der Kommunikationsweg über mobile Zwischenspeicher wie externe Festplatten beziehungsweise USB-Speicher.

Denkbar ist auch, dass vom Hersteller mehrere alternative Anlagen mit den Maschinenkomponenten konfiguriert und entsprechend mehrere virtuelle Anlagenvarianten mit den jeweils zugeordneten virtuellen 3D-Maschinenmaßblättern für den Anlagenbetreiber in einer Datenbank abgelegt werden, wobei die virtuellen Anlagenvarianten mit den jeweils zugeordneten virtuellen 3D-Maschinenmaßblättern aus der Datenbank über eine Netzwerkdatenverbindung an den Anlagenbetreiber übertragen und wahlweise in der erfassten Realumgebung virtuell angeordnet werden. Dadurch können ganze Anlagenvarianten als Blöcke in der Datenbank hinterlegt werden, um deren Anordnung in der Realumgebung schnell und zuverlässig zu überprüfen. Beispielsweise können Anlagenvarianten mit Geradläufer- oder Rundläufermaschinen als Alternativen angeboten und geprüft werden.

Denkbar ist zudem, dass das wenigstens eine virtuelle 3D-Maschinenmaßblatt auf einem mobilen Computer erzeugt und in einer Datenbank auf dem mobilen Computer abgelegt wird, wobei auf dem mobilen Computer das wenigstens eine zugeordnete, virtuelle 3D-Maschinenmaßblatt aus der Datenbank abgerufen und in der erfassten Realumgebung virtuell angeordnet wird. Dadurch kann die Konfiguration vor Ort beim Anlagenbetreiber ausgeführt werden und vorzugsweise unmittelbar danach als Ergebnis in der erfassten Realumgebung virtuell angeordnet werden. Die Datenbank kann beispielsweise eine oder mehrere Dateien auf einem Speichermedium des mobilen Computers umfassen, um das wenigstens eine zugeordnete, virtuelle 3D-Maschienenmaßblatt zu speichern.

Die wenigstens eine Maschinenkomponente und/oder das wenigstens eine virtuelle 3D-Maschinenmaßblatt kann in einer Datenbank abgelegt werden. Mit der Datenbank ist ein besonders einfacher Zugriff durch den Hersteller und den Anlagenbetreiber auf die wenigstens eine Maschinenkomponente und/oder das wenigstens eine virtuelle 3D-Maschinenmaßblatt möglich. Dadurch kann das Verfahren besonders schnell und unkompliziert durchgeführt werden. Denkbar ist auch, dass das wenigstens eine virtuelle 3D-Maschinenmaßblatt vom Hersteller aus der Datenbank ausgelesen und über die Netzwerkdatenverbindung an den Anlagenbetreiber übertragen wird. Bei der Netzwerkdatenverbindung kann es sich beispielsweise um eine Internetverbindung handeln. Vorzugsweise kann das wenigstens eine 3D-Maschinenmaßblatt aus der Datenbank mittels einer E-Mail oder dergleichen übertragen werden. Denkbar ist auch, dass der Anlagenbetreiber mit einer E-Mail einen Link zu dem wenigstens einen virtuellen 3D-Maschinenmaßblatt in der Datenbank erhält und es dann direkt herunterlädt. Denkbar ist jedoch auch, dass von einer Software, einer App oder mittels von einem Computer ausführbaren Instruktionen über die Netzwerkdatenverbindung direkt auf die Datenbank zugegriffen wird.

Vorzugsweise kann die Erfassung der Realumgebung und die virtuelle Anordnung des wenigstens einen virtuellen 3D-Maschinenmaßblatts in der erfassten Realumgebung mittels eines mobilen Computers verfolgen, vorzugsweise mit einem Laptopcomputer, einem Tabletcomputer, einer Datenbrille oder mit einem Smartphone. Dadurch kann der Anlagenbetreiber als Kunde besonders einfach mit bestehender Hardware die Anordnung erzeugen und prüfen. Denkbar ist, dass der Anlagenbetreiber dazu auf dem mobilen Computer eine vom Hersteller zur Verfügung stellte Software oder App installiert, um die Verfahrensschritte zur Erfassung der Realumgebung und zur virtuellen Anordnung des wenigstens einen virtuellen 3D-Maschinenmaßblatts in der Realumgebung durchzuführen.

Denkbar ist, dass das Kamerasystem in dem mobilen Computer integriert ist. Dadurch muss keine spezielle Hardware für das Kamerasystem angeschafft werden. Vorzugsweise kann es sich also bei dem Kamerasystem um eine Kamera des mobilen Computers handeln, beispielsweise die Kamera eines Tabletcomputers.

Vorzugsweise kann das Kamerasystem eine Kamera mit einem CCD- oder CMOS-Bildsensor und ein Objektiv umfassen. Weiter kann das Kamerasystem eine Datenverbindung zum mobilen Computer umfassen, um erfasste Bilddaten zu übertragen.

Die virtuellen 3D-Maschinenmaßblätter können beim Anordnen gegenüber der erfassten Realumgebung verschoben und/oder rotiert werden, um unterschiedliche Maschinenanordnungen auf Installationsvarianten hin durchzuspielen. Dadurch ist es möglich, vor Ort in der Realumgebung die unterschiedlichen Maschinenanordnungen miteinander einfach und zuverlässig zu vergleichen. "Verschieben" kann hier bedeuten, dass die Positionen der virtuellen 3D-Maschinenmaßblätter gegenüber der erfassten Realumgebung verändert werden.

Die virtuelle Anordnung des wenigstens einen virtuellen 3D-Maschinenmaßblatts kann in der erfassten Realumgebung auf eine Kollision mit wenigstens einem anderen Objekt hin geprüft werden. Dadurch ist sichergestellt, dass sich keine Maschinenteile überlappen und es dann bei der Installation zu einer aufwendigen Änderung der geplanten Anordnung kommt. Das wenigstens eine andere Objekt kann ein durch ein anderes virtuelles 3D-Maschinenmaßblatt repräsentiertes Objekt, ein Objekt in der Realumgebung (beispielsweise eine Wand, Versorgungsschächte und dergleichen) und/oder ein Objekt in der erfassten Realumgebung umfassen. Vorzugsweise kann bei der Kollisionsprüfung eine Überlappung des wenigstens einen virtuellen 3D-Maschinenmaßblatts mit dem Objekt der Realumgebung bestimmt werden.

Die Realumgebung kann als wenigstens ein Kamerabild erfasst werden, wobei das wenigstens eine virtuelle 3D-Maschinenmaßblatt gegenüber dem wenigstens einen Kamerabild perspektivisch angeordnet wird. Durch die perspektivische Anordnung in dem wenigstens einen Kamerabild kann die Maschinenkonfiguration so wiedergegeben werden, dass die Bedienperson einen besonders realistischen Eindruck erhält. Anders ausgedrückt kann es sich bei der perspektivischen Anordnung des virtuellen 3D-Maschinenmaßblatts um die gleiche Bildperspektive handeln, wie die der erfassten Realumgebung.

Darüber hinaus stellt die Erfindung wenigstens ein von einem Computersystem auslesbares Speichermedium mit den Merkmalen des Anspruchs 11, einen Computer zur Planung einer Anlage im Bereich der Getränkeverarbeitungsindustrie mit den Merkmalen des Anspruchs 12 und einen mobilen Computer zur Planung einer Anlage im Bereich der Getränkeverarbeitungsindustrie mit den Merkmalen des Anspruchs 13 bereit.

Dadurch, dass die lesbaren Instruktionen den Computer beim Hersteller anweisen, die Anlage im Bereich der Getränkeverarbeitungsindustrie mit mehreren Maschinenkomponenten aufgrund der Aufgabenvorgabe zu konfigurieren, werden die Maschinentypen und/oder eine spezielle Anordnung von Maschinenteilen bei der Planung berücksichtigt. Dadurch, dass aus der wenigstens einen konfigurierten Maschinenkomponente das wenigstens eine zugeordnete virtuelle 3D-Maschinenmaßblatt erzeugt wird, kann die Ausdehnung der jeweiligen Maschinenkomponente nicht nur als 2D-Projektion sondern als 3D-Körper berücksichtigt werden. Zudem können dadurch bei der Planung jeweils unterschiedliche Querschnitte der wenigstens einen Maschinenkomponente in unterschiedlicher Höhe berücksichtigt werden. Anschließend werden die virtuellen 3D-Maschinenmaßblätter dem Anlagenbetreiber als alternative Maschinenvarianten in der Datenbank zur Verfügung gestellt.

Da die ausführbaren Instruktionen den mobilen Computer beim Anlagenbetreiber dazu anweisen, die Realumgebung zur Installation der wenigstens einen Maschinenkomponente mit dem Kamerasystem zu erfassen, werden die tatsächlichen Räumlichkeiten für die Anlage und nicht nur ein möglicherweise unvollständiger oder fehlerhafter Plan erfasst. Daher werden Unterschiede zwischen den tatsächlichen Räumlichkeiten und der Planung vermieden. Zudem wird der mobile Computer angewiesen, die virtuellen 3D-Maschinenmaßblätter von der Datenbank über die Netzwerkdatenverbindung an den mobilen Computer zu übertragen. Dadurch werden die virtuellen 3D-Maschinenmaßblätter auf einfache Art und Weise vom Computer beim Hersteller auf den mobilen Computer beim Anlagenbetreiber übertragen und stehen dort zur Verfügung. Da das wenigstens eine virtuelle 3D-Maschinenmaßblatt in der erfassten Realumgebung virtuell angeordnet wird, kann eine Bedienperson besonders zuverlässig und schnell erkennen, ob die wenigstens eine Maschinenkomponente ungehindert aufgestellt werden kann. Beispielsweise kann in der virtuellen Anordnung besonders einfach und zuverlässig überprüft werden, ob die Maschinenkomponente mit einer von oben herabstehenden Einheit, beispielsweise einem Lüftungsschacht, kollidiert. Darüber hinaus ist es mit dem Verfahren möglich, Änderungen in der Planung schnell und zuverlässig zu prüfen.

Darüber hinaus stellt die Erfindung mit dem Anspruch 14 einen mobilen Computer zur Planung einer Anlage im Bereich der Getränkeverarbeitungsindustrie bereit. Dadurch, dass die Konfiguration der wenigstens einen Maschinenkomponente, die Erzeugung und Anordnung des wenigstens einen zugeordneten, virtuellen 3D-Maschinenmaßblatt in der Realumgebung auf dem mobilen Computer erfolgt, kann die Anlage vor Ort konfiguriert und vorzugsweise unmittelbar danach als Ergebnis in der Realumgebung angezeigt werden.

Bei den von dem Computersystem, dem Computer und/oder dem mobilen Computer lesbaren Instruktionen kann es sich um ein Computerprogramm, eine App und/oder eine Software handeln.

Der vorzugsweise stationären Computer kann beim Hersteller der Anlage im Bereich der Getränkeverarbeitungsindustrie angeordnet sein. Bei dem vorzugsweise stationären Computer kann es sich um einen PC, einen Laptop oder dergleichen handeln. Demgegenüber kann der mobile Computer beim Anlagenbetreiber angeordnet sein oder diesem zur Verfügung gestellt werden. Bei dem mobilen Computer kann es sich um einen Laptop, einen Tabletcomputer, eine Datenbrille oder um ein Smartphone handeln.

Bei der Netzwerkdatenverbindung kann es sich um ein Computernetzwerk handeln, das vorzugsweise einen Teil des Internets nutzt. Beispielsweise kann die Netzwerkdatenverbindung mittels fest verlegter Netzwerkkabel und/oder über eine Funkdatenverbindung erfolgen (WLAN, Bluetooth und/oder ein mobiles Datennetzwerk). Alternativ können die 3D-Modelle auch über mobile Zwischenspeicher wie externe Festplatten beziehungsweise USB-Speicher bereitgestellt werden.

Das Speichermedium kann eine Festplatte, einen mobilen Speicherstick (z.B. USB-Stick), eine CD, eine DVD, eine Blueray-Disk, einen Speicherchip und/oder ein Speichermodul umfassen.

Mit Computersystem, Computer, stationärer Computer und/oder mobiler Computer kann hier jeweils eine Einheit gemeint sein, die eine CPU, ein Speichermedium, einen Datenbus und/oder eine Schnittstelle zu der Netzwerkdatenverbindung umfasst. Vorzugsweise können die Einheiten jeweils einen Bildschirm, eine Eingabeeinheit, beispielsweise eine Tastatur und/oder einen Touchscreen umfassen.

Darüber hinaus können das wenigstens eine von dem Computersystem auslesbare Speichermedium, der vorzugsweise stationärer Computer und/oder der mobile Computer dazu ausgebildet sein, die zuvor beschriebenen Verfahrensschritte einzelnen oder in beliebigen Kombinationen, vorzugsweise nach einem der Ansprüche 1 - 10 auszuführen.

Weitere Merkmale und Vorteile der Erfindung werden nachfolgend anhand der in den Figuren dargestellten Ausführungsbeispiele näher erläutert. Dabei zeigt:
- Figur 1: ein Ausführungsbeispiel eines erfindungsgemäßen Verfahrens zur Planung einer Anlage im Bereich der Getränkeverarbeitungsindustrie als Flussdiagramm;
- Figur 2: ein Ausführungsbeispiel eines erfindungsgemäßen, stationären Computers beim Hersteller der Anlage im Bereich der Getränkeverarbeitungsindustrie zur Durchführung von Teilschritten des Verfahrens aus der Figur 1 in einer perspektivischen Darstellung;
- Figur 3: ein Ausführungsbeispiel eines erfindungsgemäßen, mobilen Computers beim Anlagenbetreiber zur Durchführung von Teilschritten des Verfahrens aus der Figur 1 in einer perspektivischen Darstellung; und
- Figur 4: eine Detailansicht des mobilen Computers aus der Figur 3 in einer Frontalansicht.

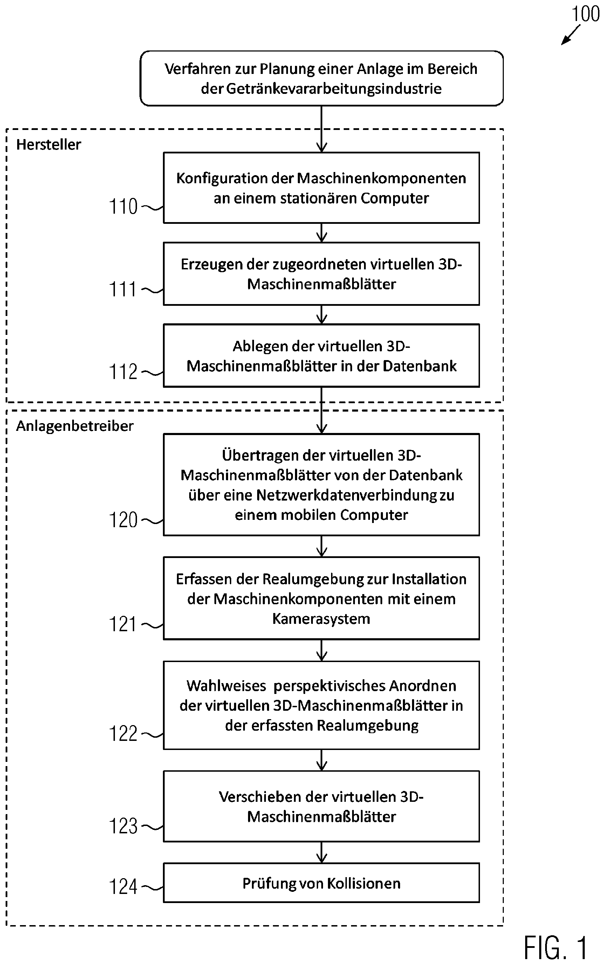

In der Figur 1 ist ein Ausführungsbeispiel des erfindungsgemäßen Verfahrens 100 zur Planung einer Anlage im Bereich der Getränkeverarbeitungsindustrie als Flussdiagramm dargestellt. Bei dem Verfahren 100 werden die Schritte 110-112 beim Hersteller der Anlage (bzw. der wenigstens einen Maschinenkomponente) und die Schritte 120-124 beim Anlagenbetreiber durchgeführt.

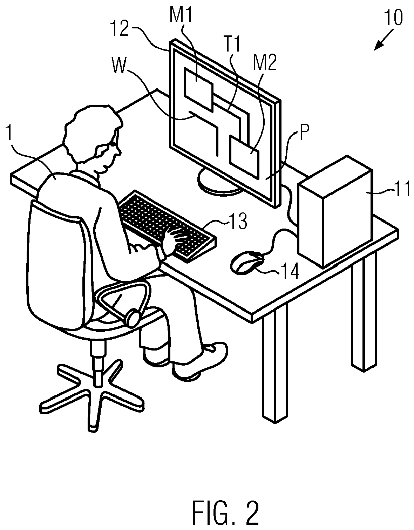

Beim Hersteller der Anlage ist ein stationärer Computer mit einer Software mit computerlesbaren Instruktionen aufgestellt, um die Schritte 110-112 durchzuführen (vgl. Fig. 2).

Im Schritt 110 werden die Maschinenkomponenten aufgrund einer Aufgabenvorgabe an dem stationären Computer konfiguriert. Die Aufgabenvorgabe umfasst beispielsweise den Maschinentyp der jeweiligen Maschinenkomponente, die Behältertypen die damit verarbeitet werden sollen, die in die Behälter abzufüllenden Produkte, die Maschinenleistung, etc.. Daraufhin konfiguriert eine Bedienperson, beispielsweise ein Produktspezialist, die einzelnen Maschinenkomponenten und legt damit deren genaue Geometrie fest.

Im Schritt 111 werden dann aus den konfigurierten Maschinenkomponenten die zugeordneten virtuellen 3D-Maschinenmaßblätter erzeugt. Da mit der Konfiguration unter anderem die Geometrie der jeweiligen Maschinenkomponente festgelegt wird, kann jetzt ein entsprechendes Geometriemodell für jedes virtuelle 3D-Maschinenmaßblatt erzeugt werden. Darüber hinaus kann das 3D-Maschinenmaßblatt weitere Informationen über die konfigurierten Maschinenkomponenten umfassen, beispielsweise den Maschinentyp, die Maschinenleistung, und dergleichen. Das Geometriemodell kann Dreiecks- und/oder Vierecksflächenelemente umfassen, die wenigstens ein zusammenhängendes Flächennetzwerk als Repräsentation der zugeordneten Maschinenkomponente bilden. Darüber hinaus kann das 3D-Maschinenmaßblatt geometrische Maßangaben umfassen.

Im nachfolgenden Schritt 112 werden die virtuellen 3D-Maschinenmaßblätter in einer Datenbank abgelegt. Die Datenbank kann beispielsweise auf einem Server-Computer implementiert sein, auf den über eine Netzwerkdatenverbindung zugegriffen werden kann. Beispielsweise kann die Netzwerkdatenverbindung auch über das Internet zugänglich sein, so dass der Anlagenbetreiber auf die virtuellen 3D-Maschinenmaßblätter in der Datenbank zugreifen kann.

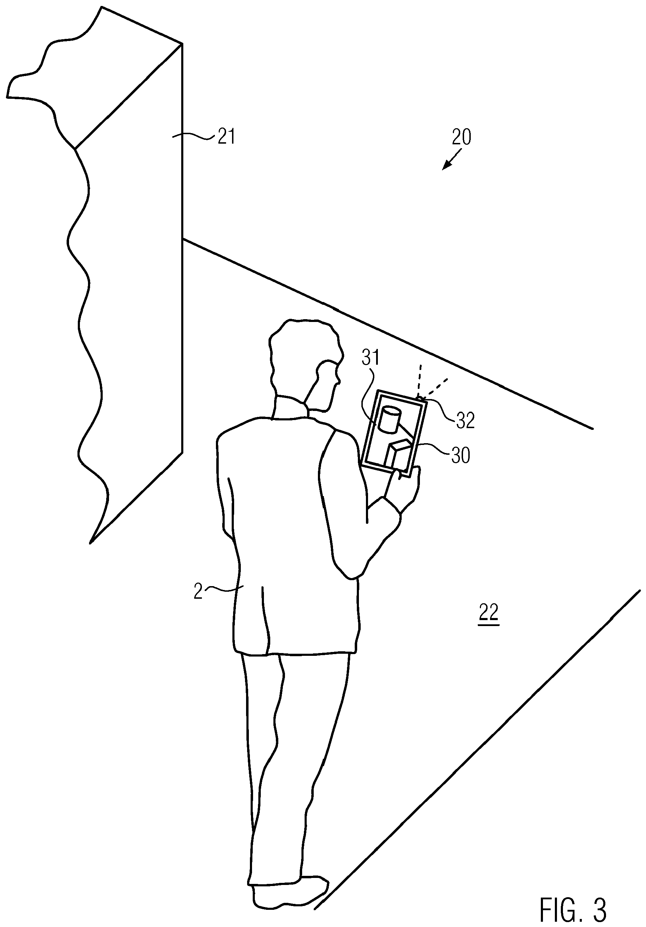

Beim Anlagenbetreiber ist eine App mit computerlesbaren Instruktionen auf einem mobilen Computer installiert, um die Verfahrensschritte 120-124 durchzuführen (vgl. Fig. 3 - 4). Bei dem mobilen Computer kann es sich beispielsweise um einen Tabletcomputer handeln.

Bei der Anlage im Bereich der Getränkeverarbeitungsindustrie kann es sich beispielsweise um eine Anlage handeln, um ein Getränk in Behälter, vorzugsweise in Flaschen abzufüllen.

Zunächst werden im Schritt 120 die virtuellen 3-D-Maschinenmaßblätter von der Datenbank über die Netzwerkdatenverbindung zu dem mobilen Computer hin übertragen. Beispielsweise kann dazu vom Hersteller zum Anlagenbetreiber eine E-Mail mit einem Link zur Datenbank geschickt werden. Ebenso ist denkbar, dass dazu beim Hersteller die virtuellen 3D-Maschinenmaßblätter als Datei aus der Datenbank ausgelesen und per E-Mail an den Anlagenbetreiber geschickt werden.

Anschließend wird im Schritt 121 mit einem Kamerasystem des mobilen Computers die Realumgebung zur Installation der Maschinenkomponenten erfasst. Beispielsweise handelt es sich bei der Realumgebung um eine Maschinenhalle, in der die Anlage später installiert werden soll. Der mobile Computer wird dabei von einer Bedienperson so gehalten, dass das Kamerasystem die Realumgebung erfasst. Vorzugsweise wird dabei der Teil der Realumgebung mit dem Kamerasystem erfasst, der für die Installation der Maschinenkomponenten vorgesehen ist.

Die Erfassung der Realumgebung erfolgt hier als Bilddaten, die vorzugsweise laufend während des nachfolgenden Schritts 122 optional während der Schritte 123-124 weiterläuft, so dass die Bilddaten mit der Bewegung des mobilen Computers konsistent sind.

Im Schritt 122 werden dann wahlweise die virtuellen 3-D-Maschinenmaßblätter in der erfassten Realumgebung perspektivisch angeordnet. Dazu werden die Bilddaten des Kamerasystems bezüglich der Bildperspektive und des Standorts des Kamerasystems mittels Bildverarbeitung ausgewertet. Durch eine Kalibrierung der Abbildungseigenschaften des Kamerasystems ist es möglich, dass der Abbildungsmaßstab bestimmt und dadurch bei der virtuellen Anordnung die Größenverhältnisse in der erfassten Realumgebung berücksichtigt werden.

Darüber hinaus ist aufgrund der Konfiguration der Maschinenkomponenten und/oder aufgrund von Vorgaben der Bedienperson beim Anlagenbetreiber die Positionen der jeweiligen Maschinenkomponente in der Realumgebung vorgegeben. Dementsprechend werden dann die 3D-Maschinenmaßblätter in der erfassten Realumgebung perspektivisch angeordnet, so dass sie an einem Bildschirm des mobilen Computers mit der erfassten Realumgebung an der Position überlagert erscheinen. Anders ausgedrückt werden die virtuellen 3D-Maschinenmaßblätter so in der erfassten Realumgebung dargestellt, als wie wenn sie dort bereits installiert wären. Zudem kann die Bedienperson wahlweise einzelne virtuelle 3D-Maschinenmaßblätter anordnen, beispielsweise um alternative Maschinenvarianten zu bewerten.

Im optionalen Schritt 123 kann dann die Bedienperson die virtuellen 3D-Maschinenmaßblätter in der erfassten Realumgebung verschieben, beispielsweise um eine alternative Position einer Maschinenkomponente zu überprüfen.

In einem weiteren optionalen Schritt 124 wird dann ermittelt, ob Kollisionen vorliegen. Dabei können sowohl Kollisionen der virtuellen 3D-Maschinenmaßblätter (und damit der Maschinenkomponenten) untereinander als auch mit Objekten der Realumgebung geprüft werden. Bei der Prüfung der virtuellen 3D-Maschinenmaßblätter untereinander werden Überlappungen der Geometriemodelle berechnet. Umgekehrt kann die Bedienperson eine Kollision eines virtuellen 3D-Maschinenmaßblatts mit einem Objekt der Realumgebung visuell am Bildschirm erkennen.

Da in den virtuellen 3D-Maschinenmaßblättern die Ausdehnung der konfigurierten Maschinenkomponenten in allen drei Raumrichtungen abgelegt sind, können auch sehr komplexe geometrische Verhältnisse der konfigurierten Maschinenkomponenten vor Ort beim Anlagenbetreiber schnell und sicher in der erfassten Realumgebung angeordnet und überprüft werden. Darüber hinaus können auch Maschinenvarianten besonders einfach alternativ angeordnet und deren Vorteile bzw. Nachteile bei der späteren Installation bewertet werden.

Denkbar ist auch, dass bei dem Verfahren 100 vom Hersteller mehrere alternative Anlagen mit den Maschinenkomponenten konfiguriert werden und entsprechend mehrere virtuelle Anlagenvarianten mit den jeweils zugeordneten virtuellen 3D-Maschinenmaßblättern für den Anlagenbetreiber in der Datenbank abgelegt werden, und das die virtuellen Anlagenvarianten mit den jeweils zugeordneten virtuellen 3D-Maschinenmaßblättern aus der Datenbank über die Netzwerkdatenverbindung an den Anlagenbetreiber übertragen und wahlweise in der erfassten Realumgebung virtuell angeordnet werden. Dadurch kann die Bedienperson besonders schnell und sicher die Installationen der verschiedenen Anlagevarianten prüfen.

In der Figur 2 ist ein Ausführungsbeispiel eines erfindungsgemäßen, stationären Computers 10 beim Hersteller der Anlage im Bereich der Getränkeverarbeitungsindustrie zur Durchführung der Teilschritte 110 - 112 des Verfahrens 100 aus der Figur 1 in einer perspektivischen Darstellung gezeigt.

Zu sehen ist die Bedienperson 1, die gerade an einem Schreibtisch mit dem Computer 10 die Schritt 110-112 des zuvor beschriebenen Verfahrens 100 zur Planung der Anlage im Bereich der Getränkeverarbeitungsindustrie durchführt. Der Computer 10 ist hier beispielsweise stationär ausgebildet und umfasst einen PC (Personal Computer) 11, einen Bildschirm 12, eine Tastatur 13 und eine Computermaus 14. Der stationäre Computer 10 ist mit einem Speichermedium ausgebildet, auf dem als Software vom stationären Computer 10 lesbare Instruktionen abgespeichert sind, die wenn sie ausgeführt werden, den stationären Computer 10 anweisen, die Schritte 110-112 durchzuführen. Denkbar ist, dass alternativ ein Laptopcomputer eingesetzt wird.

Zu sehen sind auf dem Bildschirm 12 rein beispielhaft die Maschinenkomponenten M1, T1 und M2, die auf dem Plan P angeordnet werden. Bei der Maschinenkomponente M1 handelt es sich beispielsweise um eine Abfüllmaschine, um ein Getränk in Behälter abzufüllen. Bei der Maschinenkomponente T1 handelt es sich beispielsweise um einen Transporteur, um die Behälter mit dem darin abgefüllten Getränk zu der nachfolgende Maschinenkomponente M2 zu transportieren, die hier beispielsweise als Etikettiermaschine ausgebildet ist.

Bei der Konfiguration der Maschinenkomponenten M1, T1, M2 gemäß Schritt 110 wählt die Bedienperson 1 für die Abfüllmaschine M1 unter anderem aus, dass es sich hier um eine Abfüllmaschine für Kunststofflaschen handelt, die als Rundläufermaschinen ausgebildet sein soll. Bei dem Transporteur T1 wählt die Bedienperson 1 unter anderem aus, dass es sich um einen Lineartransporteur handelt, der die Behälter aufgrund einer Wand W um eine 90°-Kurve transportiert. Zudem wählt die Bedienperson 1 bei der Etikettiermaschine M2 unter anderem aus, dass damit Sleeve-Etiketten verarbeitet werden. Außerdem können unterschiedliche Maschinengrößen für unterschiedliche Verarbeitungsgeschwindigkeiten, Behälterdurchmesser oder- Volumen abgebildet werden.

Anschließend werden von der Software aus den konfigurierten Maschinenkomponenten M1, T1, M2 automatisch die zugeordneten virtuellen 3D-Maschinenmaßblätter gemäß Schritt 111 als Datensätze erzeugt und in einer hier nicht genauer dargestellten Datenbank gemäß Schritt 112 abgelegt.

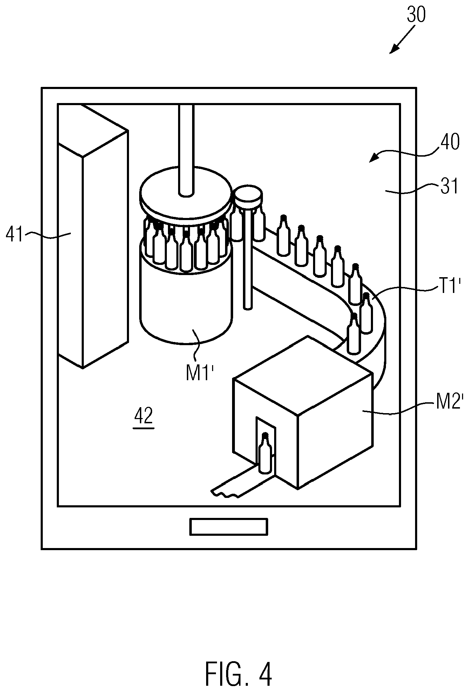

In der Figur 3 ist ein Ausführungsbeispiel eines erfindungsgemäßen, mobilen Computers 30 beim Anlagenbetreiber zur Durchführung der Teilschritte 120 - 124 des Verfahrens 100 aus der Figur 1 in einer perspektivischen Darstellung gezeigt. Ferner ist in der Figur 4 eine Detailansicht des mobilen Computers aus der Figur 3 in einer Frontalansicht dargestellt. Auf dem mobilen Computer 30 ist eine App zur Durchführung der Schritte 120-124 installiert.

Zu sehen ist in der Figur 3 die Realumgebung 20, beispielsweise eine im Wesentlichen leere Maschinenhalle mit dem Boden 22. Zudem ist die Wand 21 zu sehen, die auch in der Figur 2 im Plan P am Bildschirm 12 rein schematisch als Wand W zu sehen ist.

Eine Bedienperson 2 hält beim Anlagenbetreiber einen mobilen Computer 30 vor sich in der Hand, beispielsweise einen Tabletcomputer. Dieser umfasst einen als Touchscreen ausgebildeten Bildschirm 31 und ein Kamerasystem 32. Zudem umfasst der mobile Computer 30 eine vorzugsweise WLAN-Schnittstelle und/oder Mobilfunkdatenschnittstelle als Teil einer Netzwerkdatenverbindung, über die die virtuellen 3D-Maschinenmaßblätter von der Datenbank aus zu dem mobilen Computer 30 hin übertragen werden (Schritt 120).

Darüber hinaus ist zu sehen, dass die Bedienperson 2 den mobilen Computer 30 so in der Hand hält, dass mit dem Kamerasystem 32 die Realumgebung 20 erfasst und als Bild auf dem Bildschirm 31 dargestellt wird (Schritt 121). Zudem werden am Bildschirm 31 wahlweise die virtuellen 3D-Maschinenmaßblätter in der erfassten Realumgebung perspektivisch angeordnet (Schritt 122).

Die Darstellung am Bildschirm 31 ist genauer in der Figur 4 dargestellt. Dort ist zu sehen, dass am Bildschirm 31 bildhaft die erfasste Realumgebung 40 mit dem Boden 42 und der Wand 41 angezeigt werden. Darüber hinaus sind in der erfassten Realumgebung 40 virtuell die 3D-Maschinenmaßblätter M1', T1' und M2' angeordnet. Dadurch bekommt die Bedienperson 2 einen Eindruck davon, wie nach der Installation die Maschinenkomponenten M1, T1 und M2 in der erfassten Realumgebung 40 angeordnet sind. Darüber hinaus kann die Bedienperson 2 schnell und sicher prüfen, ob sich beispielsweise das 3D-Maschinenmaßblatt M1' (Abfüllmaschine) mit der Wand 41 überlappt. Dadurch können Kollisionen vermieden werden (vgl. Schritt 124). Darüber hinaus kann die Bedienperson 2 am Bildschirm 31 alle 3D-Maschinenmaßblätter M1', T1' und M2' einzeln, gruppenweise oder als Ganzes verschieben, um sie anders anzuordnen.

Dadurch, dass die Software den stationären Computer 10 beim Hersteller anweisen, die Anlage mit mehreren Maschinenkomponenten M1, T1, M2 aufgrund der Aufgabenvorgabe zu konfigurieren, werden die Maschinentypen und/oder eine spezielle Anordnung von Maschinenteilen bei der Planung berücksichtigt. Dadurch, dass aus den konfigurierten Maschinenkomponenten M1, T1, M2 die zugeordneten virtuellen 3D-Maschinenmaßblätter M1', T1', M2' erzeugt werden, kann die Ausdehnung der jeweiligen Maschinenkomponente M1, T1, M2 nicht nur als 2D-Projektion sondern als 3D-Körper berücksichtigt werden. Zudem können dadurch bei der Planung jeweils unterschiedliche Querschnitte der Maschinenkomponenten M1, T1, M2 in unterschiedlicher Höhe berücksichtigt werden. Anschließend werden die virtuellen 3D-Maschinenmaßblätter M1', T1', M2' dem Anlagenbetreiber in der Datenbank zur Verfügung gestellt.

Da die ausführbaren Instruktionen der App den mobilen Computer 30 beim Anlagenbetreiber dazu anweisen, die Realumgebung 20 zur Installation der Maschinenkomponenten M1, T1, M2 mit dem Kamerasystem 32 zu erfassen, werden die tatsächlichen Räumlichkeiten für die Anlage und nicht nur ein möglicherweise unvollständiger oder fehlerhafter Plan erfasst. Daher werden Unterschiede zwischen den tatsächlichen Räumlichkeiten und der Planung vermieden. Zudem wird der mobile Computer 30 angewiesen, die virtuellen 3D-Maschinenmaßblätter M1', T1', M2' von der Datenbank über die Netzwerkdatenverbindung an den mobilen Computer 30 zu übertragen. Dadurch werden die virtuellen 3D-Maschinenmaßblätter M1', T1', M2' auf einfache Art und Weise vom stationären Computer 10 beim Hersteller auf den mobilen Computer 30 beim Anlagenbetreiber übertragen und stehen dort zur Verfügung. Da die virtuellen 3D-Maschinenmaßblätter M1', T1', M2' in der erfassten Realumgebung 40 virtuell angeordnet werden, kann eine Bedienperson 2 besonders zuverlässig und schnell erkennen, ob die Maschinenkomponenten M1, T1, M2 ungehindert aufgestellt werden können. Beispielsweise kann in der virtuellen Anordnung besonders einfach und zuverlässig überprüft werden, ob die Maschinenkomponenten M1 mit der Wand W kollidiert. Darüber hinaus ist es möglich, Änderungen in der Planung schnell und zuverlässig zu prüfen.

Denkbar ist auch, dass die Konfiguration der Maschinenkomponenten M1, T1, M2, die Erzeugung und Anordnung der zugeordneten, virtuellen 3D-Maschinenmaßblätter M1', T1', M2' in der erfassten Realumgebung 40 nur auf dem mobilen Computer 30 erfolgt. Die zugeordneten, virtuellen 3D-Maschinenmaßblätter M1', T1', M2' können dabei in einer Datenbank auf dem mobilen Computer 30 abgelegt und wieder abgerufen werden. Dadurch kann die Anlage vor Ort auf dem mobilen Computer 30 konfiguriert und unmittelbar danach als Ergebnis in der erfassten Realumgebung 40 angezeigt werden.

Es versteht sich, dass in den zuvor beschriebenen Ausführungsbeispielen genannte Merkmale nicht auf diese Merkmalskombination beschränkt sind, sondern auch einzelnen oder in beliebigen anderen Kombinationen möglich sind.

## Patentansprüche

1. Verfahren (100) zur Planung einer Anlage im Bereich der Getränkeverarbeitungsindustrie mit wenigstens einer Maschinenkomponente, wobei aufgrund einer Aufgabenvorgabe die wenigstens eine Maschinenkomponente konfiguriert (110) wird,
**dadurch gekennzeichnet, dass**
aus der wenigstens einen konfigurierten Maschinenkomponente wenigstens ein zugeordnetes virtuelles 3D-Maschinenmaßblatt erzeugt wird (111),
dass eine Realumgebung zur Installation der wenigstens einen Maschinenkomponente mit einem Kamerasystem erfasst wird (120), und
dass das wenigstens eine virtuelle 3D-Maschinenmaßblatt in der erfassten Realumgebung virtuell angeordnet wird (122).

2. Verfahren (100) nach Anspruch 1, wobei von einem Hersteller mehrere der Maschinenkomponenten konfiguriert und die zugeordneten virtuellen 3D-Maschinenmaßblätter für einen Anlagenbetreiber als alternative Maschinenvarianten in einer Datenbank abgelegt werden (112), und wobei die zugeordneten virtuellen 3D-Maschinenmaßblätter aus der Datenbank über eine Netzwerkdatenverbindung an den Anlagenbetreiber übertragen (121) und wahlweise in der erfassten Realumgebung virtuell angeordnet werden.

3. Verfahren (100) nach Anspruch 1 oder 2, wobei von einem Hersteller mehrere alternative Anlagen mit den Maschinenkomponenten konfiguriert und entsprechend mehrere virtuelle Anlagenvarianten mit den jeweils zugeordneten virtuellen 3D-Maschinenmaßblätter für einen Anlagenbetreiber in einer Datenbank abgelegt werden, und wobei die virtuellen Anlagenvarianten mit den jeweils zugeordneten virtuellen 3D-Maschinenmaßblättern aus der Datenbank über eine Netzwerkdatenverbindung an den Anlagenbetreiber übertragen und wahlweise in der erfassten Realumgebung virtuell angeordnet werden.

4. Verfahren (100) nach Anspruch 1, wobei das wenigstens eine virtuelle 3D-Maschinenmaßblatt auf einem mobilen Computer erzeugt und in einer Datenbank auf dem mobilen Computer abgelegt wird, und wobei auf dem mobilen Computer das wenigstens eine zugeordnete virtuelle 3D-Maschinenmaßblatt aus der Datenbank abgerufen und in der erfassten Realumgebung virtuell angeordnet wird.

5. Verfahren (100) nach einem der vorangegangenen Ansprüche, wobei die wenigstens eine Maschinenkomponente und/oder das wenigstens eine virtuelle 3D-Maschinenmaßblatt in einer Datenbank abgelegt wird (112).

6. Verfahren (100) nach einem der vorangegangenen Ansprüche, wobei die Erfassung der Realumgebung und die virtuelle Anordnung des wenigstens einen virtuellen 3D-Maschinenmaßblatt in der erfassten Realumgebung mittels eines mobilen Computers erfolgt, vorzugsweise mit einem Laptopcomputer, einem Tabletcomputer, einer Datenbrille oder mit einem Smartphone.

7. Verfahren (100) nach Anspruch 6, wobei das Kamerasystem in dem mobilen Computer integriert ist.

8. Verfahren (100) nach einem der vorangegangenen Ansprüche, wobei die virtuellen 3D-Maschinenmaßblätter beim Anordnen gegenüber der erfassten Realumgebung verschoben und/oder rotiert werden (123), um unterschiedliche Maschinenanordnungen auf Installationsvarianten hin durchzuspielen.

9. Verfahren (100) nach einem der vorangegangenen Ansprüche, wobei die virtuelle Anordnung des wenigstens einen virtuellen 3D-Maschinenmaßblatts in der erfassten Realumgebung auf eine Kollision mit wenigstens einem anderen Objekt hin geprüft wird (124).

10. Verfahren (100) nach einem der vorangegangenen Ansprüche, wobei die Realumgebung als wenigstens ein Kamerabild erfasst wird, und wobei das wenigstens eine virtuelle 3D-Maschinenmaßblatt gegenüber dem wenigstens einen Kamerabild perspektivisch angeordnet wird.

11. Wenigstens ein von einem Computersystem auslesbares Speichermedium, umfassend von dem Computersystem (10, 30) lesbare Instruktionen, die, wenn sie von dem Computersystem (10, 30) ausgeführt werden, das Computersystem (10, 30) anweisen, ein Verfahren nach einem der Ansprüche 1 - 10 auszuführen, wobei das Computersystem (10, 30) wenigstens einen vorzugsweise stationären Computer (10) und einen mobilen Computer (30) umfasst, die über ein Netzwerkdatenverbindung miteinander verbindbar sind.

12. Computer (10) zur Planung einer Anlage im Bereich der Getränkeverarbeitungsindustrie, vorzugsweise stationärer Computer, mit einem von dem Computer (10) auslesbaren Speichermedium, umfassend von dem Computer (10) lesbaren Instruktionen, die, wenn sie von dem Computer (10) ausgeführt werden, den Computer (10) anweisen, beim Hersteller eine Anlage im Bereich der Getränkeverarbeitungsindustrie mit mehreren Maschinenkomponenten (M1, M2, T1) aufgrund einer Aufgabenvorgabe zu konfigurieren und daraus zugeordnete virtuelle 3D-Maschinenmaßblätter (M1' M2', T1') zu erzeugen, wobei die virtuellen 3D-Maschinenmaßblätter (M1', M2', T1') für einen Anlagenbetreiber als alternative Maschinenvarianten in einer Datenbank abgelegt werden.

13. Mobiler Computer (30) zur Planung einer Anlage im Bereich der Getränkeverarbeitungsindustrie, vorzugsweise ein Laptopcomputer, ein Tabletcomputer, eine Datenbrille oder ein Smartphone mit einem von dem mobilen Computer (30) auslesbaren Speichermedium, umfassend von dem mobilen Computer (30) lesbare Instruktionen, die wenn sie von dem mobilen Computer (30) ausgeführt werden, den mobilen Computer (30) anweisen, in einem Anlagenbetreiber eine Realumgebung (20) zur Installation von Maschinenkomponenten (M1, M2, T1) mit einem Kamerasystem (32) zu erfassen, wobei den Maschinenkomponenten (M1, M2, T1) zugeordnete, virtuelle 3D-Maschinenmaßblätter (M1', M2', T1') aus einer Datenbank über eine Netzwerkdatenverbindung an den mobilen Computer (30) übertragen werden, und wobei die virtuellen 3D-Maschinenmaßblätter (M1', M2', T1') wahlweise in der erfassten Realumgebung (40) virtuell angeordnet werden.

14. Mobiler Computer (30) zur Planung einer Anlage im Bereich der Getränkeverarbeitungsindustrie, vorzugsweise ein Laptopcomputer, ein Tabletcomputer, eine Datenbrille oder ein Smartphone mit einem von dem mobilen Computer (30) auslesbaren Speichermedium, umfassend von dem mobilen Computer (30) lesbare Instruktionen, die wenn sie von dem mobilen Computer (30) ausgeführt werden, den mobilen Computer (30) anweisen, eine Anlage im Bereich der Getränkeverarbeitungsindustrie mit wenigstens einer Maschinenkomponente (M1, M2, T1) aufgrund einer Aufgabenvorgabe zu konfigurieren und daraus wenigstens ein zugeordnetes virtuelles 3D-Maschinenmaßblatt (M1', M2', T1') zu erzeugen, wobei das wenigstens eine virtuelle 3D-Maschinenmaßblatt (M1', M2', T1') in einer Datenbank auf dem mobilen Computer (30) abgelegt wird, wobei eine Realumgebung (20) zur Installation der wenigstens einen Maschinenkomponente (M1, M2, T1) mit einem Kamerasystem (32) erfasst wird, wobei das wenigstens eine virtuelle 3D-Maschinenmaßblatt (M1', M2', T1') aus der Datenbank auf dem mobilen Computer (30) ausgelesen wird, und wobei das virtuellen 3D-Maschinenmaßblatt (M1', M2', T1')in der erfassten Realumgebung (40) virtuell angeordnet wird.
